# EUROPEAN PATENT SPECIFICATION

(11) **EP 2 416 496 B1**
(45) Date of publication and mention of the grant of the patent: **01.05.2019**
(21) Application number: 10761478.6
(22) Date of filing: 27.01.2010
(51) Int. Cl.: H03H 9/64

(54) **ELASTIC WAVE FILTER**
FILTER MIT ELASTISCHEN WELLEN
FILTRE À ONDES ÉLASTIQUES

(30) Priority: 30.03.2009 JP 2009081492
(43) Date of publication of application: 08.02.2012
(73) Proprietor: Murata Manufacturing Co., Ltd., Kyoto 617-8555 (JP)
(72) Inventor: TANIGUCHI, Yasumasa, Nagaokakyo-shi Kyoto 617-8555 (JP)
(74) Representative: Delumeau, François Guy
(86) International application number: PCT/JP2010/051024
(87) International publication number: WO 2010/116776

(56) References cited:
- EP-A1- 1 503 498
- WO-A1-2007/023643
- JP-A- 2002 232 264
- JP-A- 2002 344 349
- JP-A- 2005 045 475
- JP-T- 2006 513 648
- US-A1- 2004 058 664
- US-A1- 2004 119 561
- US-A1- 2004 130 410
- US-A1- 2006 055 486
- US-A1- 2008 055 021

## Description

### Technical Field

The present invention relates to elastic wave filters, and more specifically to an elastic wave ladder filter including series arm resonators, parallel arm resonators, and inductors connected to the series arm in parallel with the series resonators.

### Background Art

In recent years, an elastic wave ladder filter using elastic wave resonators has been proposed, for example, in Patent Literature 1. More specifically, Patent Literature 1 discloses a π-type elastic wave ladder filter.

Document US2008055021 discloses an elastic wave ladder filter comprising an inductor connected in parallel to a series connection of series arm resonators.

Document US2004130410 discloses an elastic wave ladder filter comprising a bridging inductor.

### Citation List

### Patent Literature

PTL 1: Japanese Unexamined Patent Application Publication No. 2006-238101

### Summary of Invention

### Technical Problem

A basic circuit configuration of such a π-type elastic wave ladder filter disclosed in Patent Literature 1 is illustrated in Fig. 19. Referring to Fig. 19, in a π-type elastic wave ladder filter 100, a series arm resonator 104 and an inductor 105 are arranged in parallel on a series arm 103 that connects an input terminal 101 to an output terminal 102. Further, parallel arm resonators 107 are respectively arranged on two parallel arms 106 that connect the series arm 103 to the ground potential. Since an inductor 105 is provided in parallel with the series arm resonator 104 arranged on the series arm 103, the π-type elastic wave ladder filter 100 has low-pass filter characteristics.

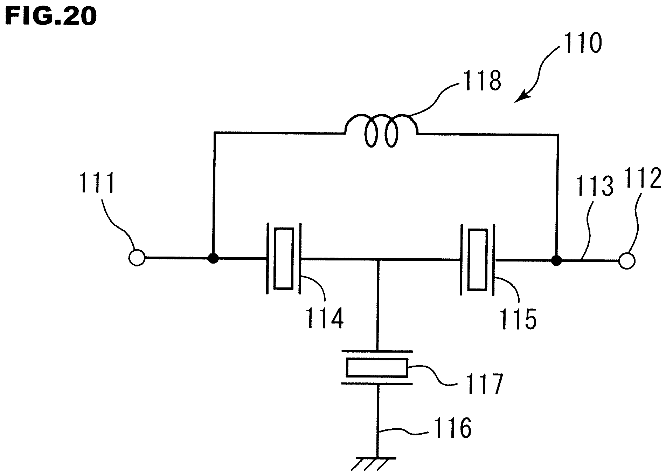

In addition, a T-type elastic wave ladder filter is known as an elastic wave ladder filter other than the π-type elastic wave ladder filter described above. Fig. 20 illustrates a basic circuit configuration of a T-type elastic wave ladder filter. Referring to Fig. 20, in a T-type elastic wave ladder filter 110, two series resonators 114 and 115 are connected in series on a series arm 113 that connects an input terminal 111 to an output terminal 112. A parallel resonator 117 is arranged on a parallel arm 116 that connects the ground potential to the connection node of a series arm resonator 114 and a series arm resonator 115. Further, an inductor 118 is connected to the series arm 113 in such a manner as to be in parallel with the series arm resonators 114 and 115.

Usually, when a stop band is formed by the anti-resonance point of a series arm resonator and the resonance point of a parallel arm resonator, a π-type elastic wave ladder filter has higher attenuation characteristics than a T-type elastic wave ladder filter. Hence, from the viewpoint of realizing high attenuation characteristics, it is advantageous to use a π-type elastic wave ladder filter. As a result, a π-type elastic wave ladder filter is often used as a trap filter.

However, to realize a plurality of stop bands having a higher attenuation characteristic in such a π-type elastic wave ladder filter, the number of stages needs to be increased, resulting in an increased number of inductors. This makes it difficult to realize a reduction in the size and cost of a π-type elastic wave ladder filter. Specifically, in the case in which π-type elastic wave ladder filters are connected in multiple stages to form a plurality of stop bands or to obtain high attenuation characteristics, the total size and cost of the ladder filters are significantly increased.

In view of the above points, it is an object of the present invention to provide a compact elastic wave filter having satisfactory characteristics.

### Solution to Problem

An elastic wave filter according to the present invention includes: a plurality of series arm resonators, an inductor, and a plurality of parallel arm resonators. The plurality of the series arm resonators are connected in series to one another on a series arm connecting an input terminal to an output terminal. The inductor is connected to first and second connection nodes on the series arm in such a manner as to be in parallel with a series connection of two or more of the plurality of the series arm resonators. The plurality of the parallel arm resonators are arranged on a parallel arm connecting the first connection node to a ground potential, on a parallel arm connecting the second connection node to a ground potential, and on a parallel arm connecting a further connection node, between adjacent series arm resonators of said series connection, to the ground potential.

In the present invention, the two or more series arm resonators, with which the inductor is connected in parallel, include a first series arm resonator and a second series arm resonator that has a resonant frequency equal to or higher than an anti-resonant frequency of the first series arm resonator. Furthermore, resonant points of the parallel arm resonators form two attenuation regions in the passband of the elastic wave filter and the first inductor forms, with equivalent circuits of the first and second series arm resonators, an LC filter having two attenuation poles arranged in said two attenuation regions.

According to this configuration, one of the first and second series arm resonators becomes inductive and the other becomes capacitive, since an elastic wave resonator becomes inductive when a frequency between the resonant frequency and anti-resonant frequency is applied, and becomes capacitive when other frequencies are applied. Hence, an LC filter is formed by the inductor and equivalent circuits of the first and second series arm resonators. As a result, the attenuation characteristics are improved. Specifically in the case in which the elastic wave filter is a trap filter having a plurality of attenuation regions (stop bands), a greater improvement in the attenuation characteristics is expected since the resonant frequency of the first series arm resonator and the resonant frequency of the second series arm resonator can be made to be located in attenuation regions (stop bands) different from one another.

In another specific aspect of the present invention, the elastic wave filter has a stop band and a pass band that is located on a lower frequency side of the stop band.

In still another specific aspect of the present invention, the elastic wave filter comprises a second filter stage having a series path, and a second inductor which is connected in parallel to the series path of the second filter stage. According to this configuration, a greater improvement in the attenuation characteristics is expected.

In still another specific aspect of the present invention, the elastic wave filter has a filter body which has the plurality of the series arm resonators and the plurality of the parallel arm resonators formed thereon and the plurality of the inductors connected thereto, and the plurality of the inductors are arranged point-symmetrically with respect to a center of the filter body. According to this configuration, better filter characteristics are realized.

In still another specific aspect of the present invention, the series connection comprises two of the plurality of the series arm resonators, and each of the plurality of the parallel arms has one of the plurality of the parallel resonators. According to this configuration, a smaller insertion loss in the pass band is realized.

In still another specific aspect of the present invention, the elastic wave filter further includes a plurality of ground terminal electrodes to which the plurality of the parallel arms are connected, and the plurality of the ground terminal electrodes are point-symmetrically arranged with respect to a center of the elastic wave filter. According to this configuration, better filter characteristics are realized.

### Advantageous Effects of Invention

According to the present invention, since the inductor provided is connected to the series arm in such a manner as to be in parallel with two or more of the plurality of the series arm resonators, compared with a π-type elastic wave ladder filter, the ratio of the number of inductors to the number of resonators can be made small, leading to a reduction in size. In addition, since the ratio of the number of resonators to the number of inductors can be made large, enhanced filter characteristics, specifically, a stop band having a broader bandwidth and higher attenuation can be realized.

### Brief Description of Drawings

Fig. 1 is a schematic diagram of an elastic wave filter according to a first embodiment.
Fig. 2 is a schematic sectional view of a surface acoustic wave resonator of which a series arm resonator and a parallel arm resonator are formed.
Fig. 3 is a schematic plan view of the surface acoustic wave resonator.
Fig. 4 is a graph illustrating the attenuation characteristics of a π-type elastic wave ladder filter and a T-type elastic wave ladder filter. In Fig. 4, the solid lines denote the attenuation characteristics of the π-type elastic wave ladder filter, and the broken lines denote the attenuation characteristics of the T-type elastic wave ladder filter.
Fig. 5 is a graph illustrating the attenuation characteristics of the elastic wave filter of the first embodiment and the attenuation characteristics of the π-type elastic wave filter. In Fig. 5, the solid lines denote the attenuation characteristics of the elastic wave filter of the first embodiment, and the broken lines denote the attenuation characteristics of the π-type elastic wave filter.
Fig. 6 is a graph illustrating the attenuation characteristics of the elastic wave filter of the first embodiment and the attenuation characteristics of the π-type elastic wave filter. In Fig. 6, the solid lines denote the attenuation characteristics of the elastic wave filter of the first embodiment, and the broken lines denote the attenuation characteristics of the π-type elastic wave filter.
Fig. 7 is a graph illustrating the attenuation characteristics of the elastic wave filter of the first embodiment and the attenuation characteristics of an elastic wave filter illustrated in Fig. 9. In Fig. 7, the solid lines denote the attenuation characteristics of the elastic wave filter of the first embodiment, and the broken lines denote the attenuation characteristics of the π-type elastic wave filter illustrated in Fig. 9.
Fig. 8 is a graph illustrating the attenuation characteristics of the elastic wave filter of the first embodiment and the attenuation characteristics of the elastic wave filter illustrated in Fig. 9. In Fig. 8, the solid lines denote the attenuation characteristics of the elastic wave filter of the first embodiment, and the broken lines denote the attenuation characteristics of the elastic wave filter illustrated in Fig. 9.
Fig. 9 is a schematic diagram of a two-filter-stage elastic wave filter.
Fig. 10 is a schematic diagram of an elastic wave filter according to a second embodiment.
Fig. 11 is a schematic diagram of a three-filter-stage π-type elastic wave ladder filter.
Fig. 12 is a graph illustrating the attenuation characteristics of the elastic wave filter according to the second embodiment and a three-filter-stage π-type elastic wave ladder filter. In Fig. 12, the solid lines denote the attenuation characteristics of the elastic wave filter of the second embodiment, and the broken lines denote the attenuation characteristics of the elastic wave filter illustrated in Fig. 11.
Fig. 13 is a schematic diagram of an elastic wave filter according to a third embodiment.
Fig. 14 is a schematic diagram of a two-filter-stage elastic-wave band pass filter.
Fig. 15 is a graph illustrating the attenuation characteristics of the elastic wave filter according to the third embodiment and the elastic-wave band pass filter illustrated in Fig. 14. In Fig. 15, the solid lines denote the attenuation characteristics of the elastic wave filter of the third embodiment, and the broken lines denote the attenuation characteristics of the elastic wave filter illustrated in Fig. 14.
Fig. 16 is a schematic diagram of an elastic wave filter according to a fourth embodiment.
Fig. 17 is a schematic diagram of the back surface of an elastic wave filter according to an example reference.
Fig. 18 is a graph illustrating the attenuation characteristics of the elastic wave filter of the fourth embodiment and the elastic wave filter illustrated in Fig. 17. In Fig. 18, the solid lines denote the attenuation characteristics of the elastic wave filter of the fourth embodiment, and the broken lines denote the attenuation characteristics of the elastic wave filter illustrated in Fig. 17.
Fig. 19 illustrates a basic circuit configuration of a π-type elastic wave ladder filter.
Fig. 20 illustrates a basic circuit configuration of a T-type elastic wave ladder filter.

### Description of Embodiments

Hereinafter, specific embodiments of the present invention are described with reference to the attached drawings, whereby the present invention is clarified.

### (First embodiment)

In the present embodiment, description is made of an elastic wave filter as a trap filter having a pass band that is a digital terrestrial broadcasting reception band (470-770 MHz) and a stop band that is an RF transmission frequency band (near 800 MHz and near 900 MHz).

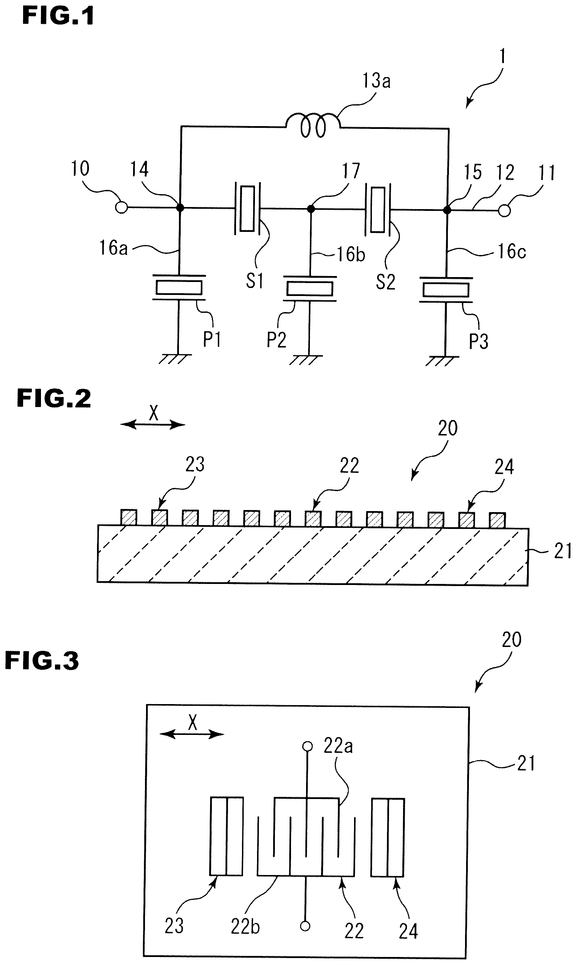

Fig. 1 is a schematic diagram of an elastic wave filter according to a first embodiment. Referring to Fig. 1, an elastic wave filter 1 includes a plurality of series arm resonators S1 and S2 connected in series on a series arm 12 that connects an input terminal 10 to an output terminal 11. Specifically, in the present embodiment, a first series arm resonator S1 and a second series arm resonator S2 are provided on the series arm 12. The anti-resonant frequency of the first series arm resonator S1 is made to be equal to or lower than the resonant frequency of the second series arm resonator S2 in the present embodiment.

An inductor 13a is connected to the series arm 12. The inductor 13a is arranged in parallel with the first and second series arm resonators S1 and S2. More specifically, the inductor 13a is connected between a connection node 14 between the first series arm resonator S1 and the input terminal 10 and a connection node 15 between the second series arm resonator S2 and the output terminal 11.

The connection node 14 of the inductor 13a and the series arm 12 is connected to the ground potential through a first parallel arm 16a. The connection node 15 of the inductor 13a and the series arm 12 is connected to the ground potential through a third parallel arm 16c. Further, a connection node 17 of the first series arm resonator S1 and the second series arm resonator S2 neighboring each other is connected to the ground potential through a second parallel arm 16b. The parallel arms 16a to 16c respectively have parallel arm resonators P1 to P3 arranged thereon.

In the present embodiment, the series arm resonators S1 and S2 and the parallel arm resonators P1 to P3 are elastic wave resonators, more specifically, surface acoustic wave resonators. However, the series arm resonators S1 and S2 and the parallel arm resonators P1 to P3 may be elastic wave resonators using elastic waves other than surface acoustic waves. For example, the series arm resonators S1 and S2 and the parallel arm resonators P1 to P3 may be boundary acoustic wave resonators using boundary acoustic waves, or thin-film bulk acoustic wave resonators.

Fig. 2 illustrates a schematic sectional view of a surface acoustic wave resonator 20 of which the series arm resonators S1 and S2 and the parallel arm resonators P1 to P3 are formed. Fig. 3 illustrates a schematic plan view of the surface acoustic wave resonator 20. Referring to Figs. 2 and 3, the surface acoustic wave resonator 20 includes an IDT electrode 22 formed on a piezoelectric substrate 21, and first and second grating reflectors 23 and 24 arranged on both sides of the IDT electrode 22 in a propagation direction x of a surface acoustic wave. Referring to Fig. 3, the IDT electrode 22 includes first and second interdigitated comb-shaped electrodes 22a and 22b.

The piezoelectric substrate 21 may be a substrate made of a piezoelectric material such as LiNbO₃ or LiTaO₃. For example, the piezoelectric substrate 21 may be a 42° Y-cut X-propagation LiTaO₃ substrate. The IDT electrode 22 and the first and second grating reflectors 23 and 24 may be formed of one or more publicly known conductive materials. For example, the IDT electrode 22 and the first and second grating reflectors 23 and 24 may be formed of Al.

Note that the series arm resonator S1 and S2 and the parallel arm resonators P1 to P3 may be formed on the same piezoelectric substrate or on separate piezoelectric substrates. In the present embodiment, an example is described in which the series arm resonators S1 and S2 and the parallel arm resonators P1 to P3 are formed on the same piezoelectric substrate 21. In the present embodiment, the piezoelectric substrate 21 on which the series arm resonators S1 and S2 and the parallel arm resonators P1 to P3 are formed is mounted face down on an alumina substrate, which is not illustrated. The piezoelectric substrate 21 mounted on the alumina substrate is sealed with a seal resin, which is not illustrated.

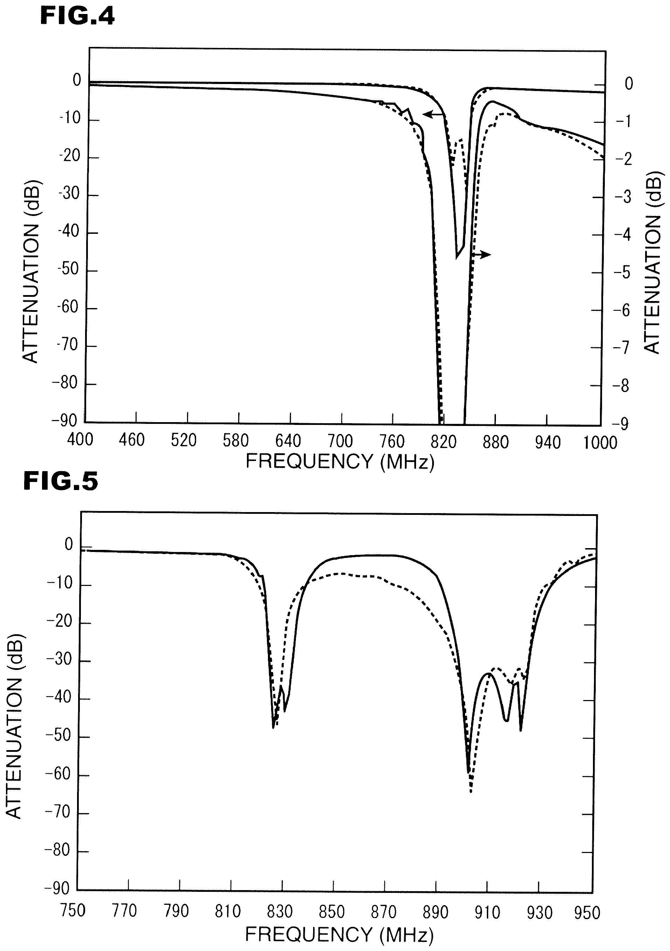

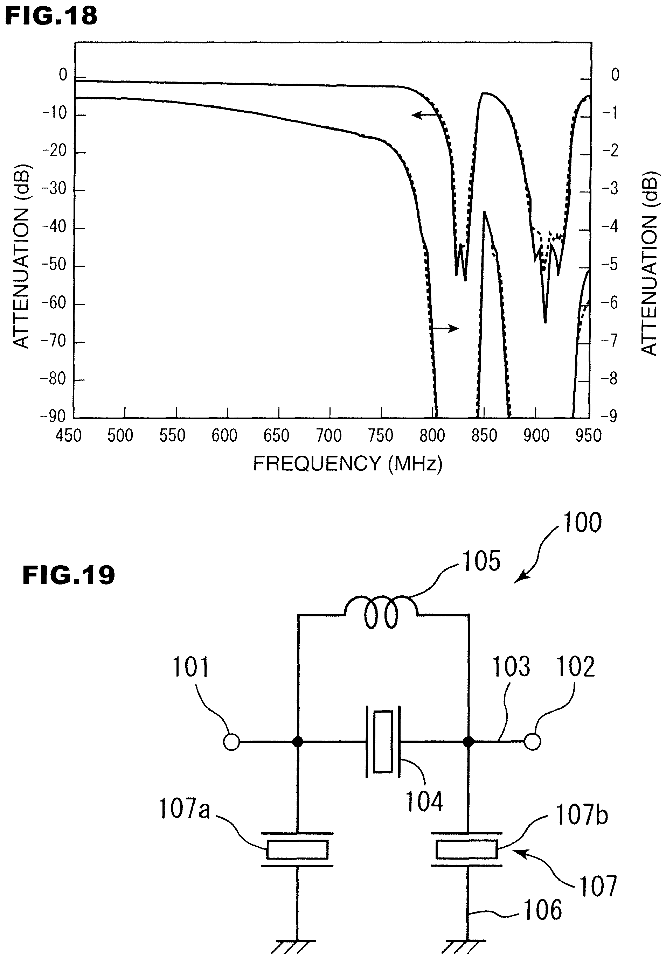

As described above, elastic wave ladder filters include a π-type elastic wave ladder filter as illustrated in Fig. 19 and a T-type elastic wave ladder filter as illustrated in Fig. 20. When comparing a π-type elastic wave ladder filter with a T-type elastic wave ladder filter, a π-type elastic wave ladder filter has higher attenuation characteristics than a T-type elastic wave ladder filter, as illustrated in Fig. 4. Hence, from the viewpoint of realizing high attenuation characteristics, it is advantageous to use a π-type elastic wave ladder filter. However, the only way to realize a plurality of stop bands (attenuation characteristics) having higher attenuation in the π-type elastic wave ladder filter as illustrated in Fig. 19 is to increase the number of stages. Since an inductor is needed for every stage, an increase in the number of stages causes increases in size and cost.

On the other hand, the elastic wave filter 1 according to the present embodiment is provided with the inductor 13a connected to the series arm 12 so as to be in parallel with the first and second series arm resonators S1 and S2. In addition, the parallel arms 16a and 16c connecting the connection nodes 14 and 15 of the inductor 13a and the series arm 12 to the ground potential, and the parallel arm resonators P1 and P3 respectively arranged on the parallel arms 16a and 16c are also provided. Hence, there exists only one inductor, that is, the inductor 13a for the two series arm resonators and the three parallel arm resonators. In other words, the number of inductors is small compared with the number of resonators in the elastic wave filter 1. As a result, a reduction in the size of the elastic wave filter 1 can be realized. In addition, since the ratio of the number of resonators to the number of inductors is high in the present embodiment, enhanced filter characteristics are realized, as will be described specifically.

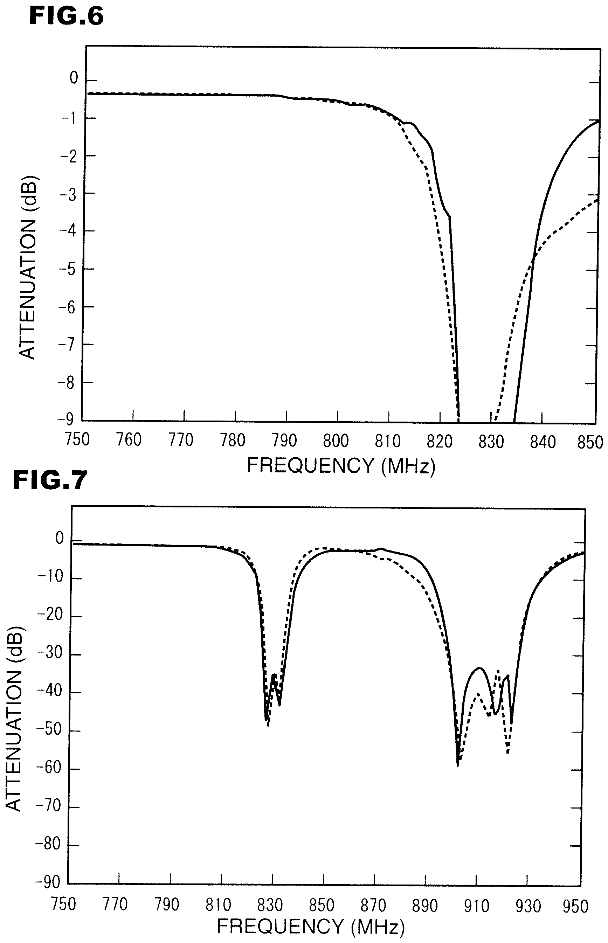

Figs. 5 and 6 are graphs respectively illustrating the attenuation characteristics of the elastic wave filter 1 and the attenuation characteristics of the π-type elastic wave filter 100 illustrated in Fig. 19. Note that in Figs. 5 and 6, the solid lines denote the attenuation characteristics of the elastic wave filter of the first embodiment, and the broken lines denote the attenuation characteristics of the π-type elastic wave filter. In Figs. 5 and 6, the design parameters for the elastic wave filter 1 and the design parameters for the elastic wave filter 100 are as follows.

### Design parameters for the elastic wave filter 1

### First parallel arm resonator P1:

IDT electrode wavelength: 4.3039 µm, reflector wavelength: 4.3039 µm, intersection width: 48.63 µm, number of IDT electrode pairs: 79, number of reflector pairs: 4.5, duty ratio ratio: 0.569, resonant frequency: 902 MHz, anti-resonant frequency: 935 MHz

### First series arm resonator S1:

IDT electrode wavelength: 4.7255 µm, reflector wavelength: 4.7255 µm, intersection width: 57.17 µm, number of IDT electrode pairs: 72, number of reflector pairs: 4.5, duty ratio ratio: 0.549, resonant frequency: 830 MHz, anti-resonant frequency: 859 MHz

### Second parallel arm resonator P2:

IDT electrode wavelength: 4.7843 µm, reflector wavelength: 4.7483 µm, intersection width: 54.9 µm, number of IDT electrode pairs: 65, number of reflector pairs: 4.5, duty ratio ratio: 0.569, resonant frequency: 819 MHz, anti-resonant frequency: 848 MHz

### Second series arm resonator S2:

IDT electrode wavelength: 4.2941 µm, reflector wavelength: 4.2941 µm, intersection width: 50.98 µm, number of IDT electrode pairs: 96 number of reflector pairs: 4.5, duty ratio ratio: 0.669, resonant frequency: 904 MHz, anti-resonant frequency: 936 MHz

### Third parallel arm resonator P3:

IDT electrode wavelength: 4.2001 µm, reflector wavelength: 4.2001 µm, intersection width: 54.9 µm, number of IDT electrode pairs: 87, number of reflector pairs: 4.5, duty ratio ratio: 0.569, resonant frequency: 922 MHz, anti-resonant frequency: 956 MHz
Inductor 13a: 7.8 nH

### Design parameters of the elastic wave filter 100:

### First parallel arm resonator 107a:

IDT electrode wavelength: 4.7353 µm, reflector wavelength: 4.7353 µm, intersection width: 40.24 µm, number of IDT electrode pairs: 90, number of reflector pairs: 4.5, duty ratio ratio: 0.569, resonant frequency: 827 MHz, anti-resonant frequency: 857 MHz

### Series arm resonator 104:

IDT electrode wavelength: 4.0784 µm, reflector wavelength: 4.0784 µm, intersection width: 60.71 µm, number of IDT electrode pairs: 58, number of reflector pairs: 4.5, duty ratio ratio: 0.569, resonant frequency: 946 MHz, anti-resonant frequency: 980 MHz

### Second parallel arm resonator 107b:

IDT electrode wavelength: 4.3039 µm, reflector wavelength: 4.3039 µm, intersection width: 97.41 µm, number of IDT electrode pairs: 55, number of reflector pairs: 4.5, duty ratio ratio: 0.569, resonant frequency: 904 MHz, anti-resonant frequency: 936 MHz
Inductor 105: 6.4 nH

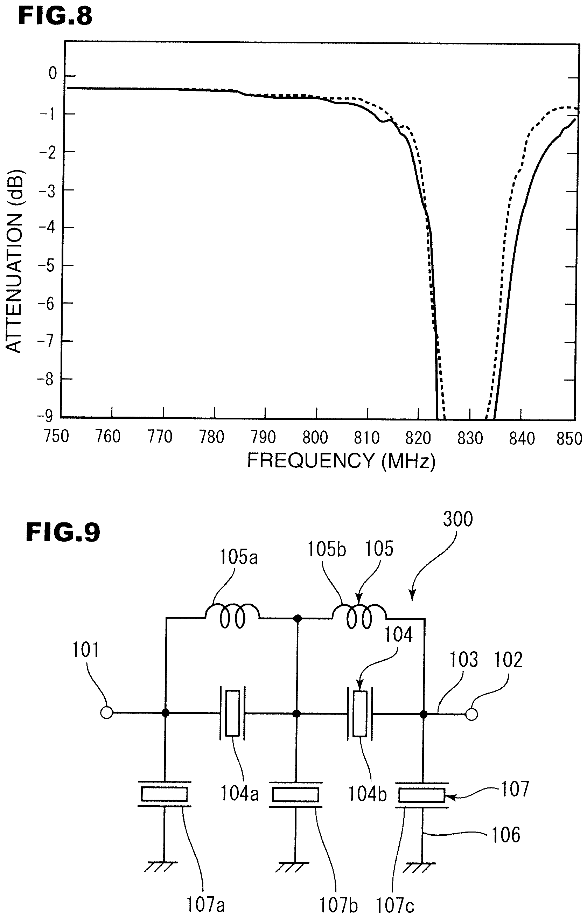

Figs. 7 and 8 respectively illustrate the attenuation characteristics of the elastic wave filter 1 and the attenuation characteristics of a two-filter-stage π-type elastic wave filter 300 illustrated in Fig. 9. Note that in Figs. 7 and 8, the solid lines denote the attenuation characteristics of the elastic wave filter 1 of the first embodiment, and the broken lines denote the attenuation characteristics of the elastic wave filter illustrated in Fig. 9. The design parameters for the elastic wave filter 1 in Fig. 7 are the same as those described above. The design parameters for the elastic wave filter 300 in Fig. 9 are as follows.

### Design parameters of the elastic wave filter 300:

### First parallel arm resonator 107a:

IDT electrode wavelength: 4.2353 µm, reflector wavelength: 4.2353 µm, intersection width: 40 µm, number of IDT electrode pairs: 90, number of reflector pairs: 4.5, duty ratio ratio: 0.569, resonant frequency: 915 MHz, anti-resonant frequency: 949 MHz

### First series arm resonator 104a:

IDT electrode wavelength: 4.6351 µm, reflector wavelength: 4.6351 µm, intersection width: 60.78 µm, number of IDT electrode pairs: 104, number of reflector pairs: 4.5, duty ratio ratio: 0.569, resonant frequency: 844 MHz, anti-resonant frequency: 875 MHz

### Second parallel arm resonator 107b:

IDT electrode wavelength: 4.7353 µm, reflector wavelength: 4.7353 µm, intersection width: 45.49 µm, number of IDT electrode pairs: 60, number of reflector pairs: 4.5, duty ratio ratio: 0.569, resonant frequency: 826 MHz, anti-resonant frequency: 856 MHz

### Second series arm resonator 104b:

IDT electrode wavelength: 4.2059 µm, reflector wavelength: 4.2059 µm, intersection width: 75.69 µm, number of IDT electrode pairs: 61, number of reflector pairs: 4.5, duty ratio ratio: 0.569, resonant frequency: 922 MHz, anti-resonant frequency: 955 MHz

### Third parallel arm resonator 107c:

IDT electrode wavelength: 4.2059 µm, reflector wavelength: 4.2059 µm, intersection width: 41.18 µm, number of IDT electrode pairs: 100, number of reflector pairs: 4.5, duty ratio ratio: 0.569, resonant frequency: 921 MHz, anti-resonant frequency: 954 MHz
Inductor 105a: 3.2 nH
Inductor 105b: 4.5 nH

Referring to Figs. 5 and 6, the elastic wave filter 1 of the present embodiment, in which a low pass filter is formed by the inductor 13a and C components of the parallel arm resonators P1 to P3, allows a wide pass band to be formed. Further, two stop bands are formed within the pass band by the resonant points of the parallel arm resonators P1 to P3. In the present embodiment, the anti-resonant frequency of the first series arm resonator S1 is made to be equal to or lower than the resonant frequency of the second series arm resonator S2. Hence, one of the first and second series arm resonators S1 and S2 becomes inductive and the other becomes capacitive. As a result, an LC filter having two attenuation poles can be formed by the inductor 13a and the first and second series arm resonators S1 and S2, and hence, by arranging the two attenuation poles in the two stop bands, the attenuation characteristics can be further improved. Hence, in the present embodiment, the stop bands have higher attenuation and wider bands than the existing single-filter-stage π-type elastic wave filter.

Further, it can be seen that, compared with the existing two-filter-stage π-type elastic wave filter, the elastic wave filter 1 of the present embodiment, although having fewer inductors, realizes approximately the same attenuation characteristics, as illustrated in Figs. 7 and 8.

As described above, according to the present embodiment, an elastic wave filter having a reduced size and high attenuation characteristics is realized.

Hereinafter, other preferred embodiments of the present invention are described. Note that in the description below, components having substantially the same functions as the components of the above-described first embodiment are denoted by the same reference numerals.

### (Second embodiment)

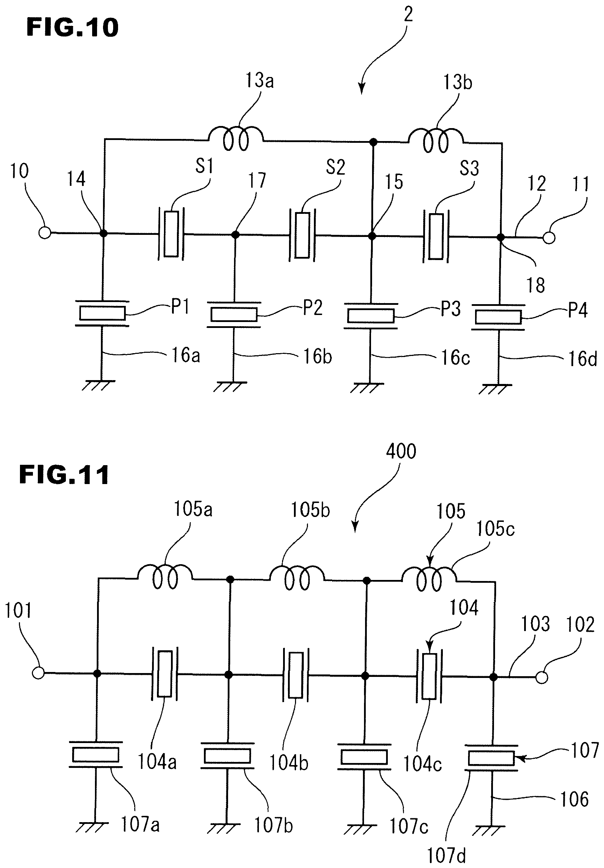

Fig. 10 is a schematic diagram of an elastic wave filter 2 according to a second embodiment. Referring to Fig. 10, in the elastic wave filter 2 of the present embodiment, a π-type elastic wave ladder filter is added to the elastic wave filter of the above-described first embodiment in a subsequent stage. More specifically, the elastic wave filter 2 includes first to third series arm resonators S1 to S3 connected in series to one another on a series arm 12. An inductor 13a is connected between a connection node 14 of the first series arm resonator S1 and an input terminal 10 and a connection node 15 of the second series arm resonator S2 and the third series arm resonator S3. In addition an inductor 13b is connected between the connection node 15 and a connection node 18 of the third series arm resonator S3 and an output terminal 11. The connection nodes 14, 17, 15, and 18 are connected to the ground potential through first to fourth parallel arms 16a to 16d. Parallel arm resonators P1 to P4 are respectively arranged on the first to fourth parallel arms 16a to 16d.

Also in the present embodiment, the anti-resonant frequency of the first series arm resonator S1 is made to be equal to or lower than the resonant frequency of the second series arm resonator S2 similarly to the first embodiment described above.

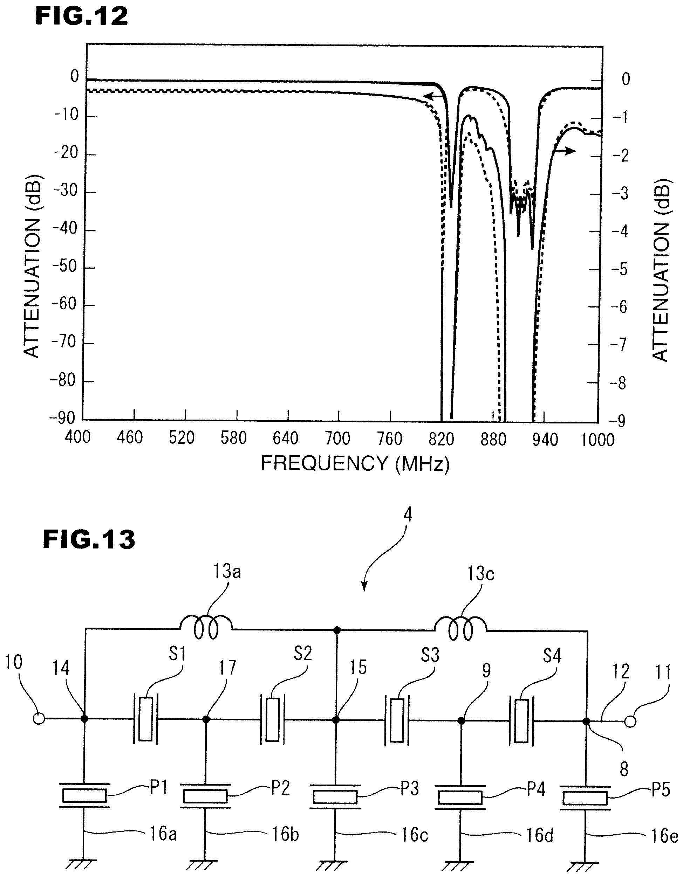

Fig. 12 illustrates the attenuation characteristics of the elastic wave filter 2 of the present embodiment. For comparison, the attenuation characteristics of a three-filter-stage π-type elastic wave ladder filter 400, as illustrated in Fig. 11, are also illustrated in Fig. 12. In Fig. 12, the solid lines denote the attenuation characteristics of the elastic wave filter of the second embodiment, and the broken lines denote the attenuation characteristics of the elastic wave filter illustrated in Fig. 11. Note that, in Fig. 12, the design parameters for the elastic wave filter 2 and the design parameters for the elastic wave filter 400 are as follows.

### Design parameters for the elastic wave filter 2

### First parallel arm resonator P1:

IDT electrode wavelength: 4.3137 µm, reflector wavelength: 4.3137 µm, intersection width: 40.39 µm, number of IDT electrode pairs: 56, number of reflector pairs: 4.5, duty ratio ratio: 0.569, resonant frequency: 899 MHz, anti-resonant frequency: 931 MHz

### First series arm resonator S1:

IDT electrode wavelength: 4.6961 µm, reflector wavelength: 4.6961 µm, intersection width: 40.39 µm, number of IDT electrode pairs: 101, number of reflector pairs: 1.5, duty ratio ratio: 0.569, resonant frequency: 829 MHz, anti-resonant frequency: 859 MHz

### Second parallel arm resonator P2:

IDT electrode wavelength: 4.7255 µm, reflector wavelength: 4.7255 µm, intersection width: 47.06 µm, number of IDT electrode pairs: 115, number of reflector pairs: 4.5, duty ratio ratio: 0.569, resonant frequency: 828 MHz, anti-resonant frequency: 857 MHz

### Second series arm resonator S2:

IDT electrode wavelength: 4.2251 µm, reflector wavelength: 4.2251 µm, intersection width: 72.55 µm, number of IDT electrode pairs: 66, number of reflector pairs: 4.5, duty ratio ratio: 0.539, resonant frequency: 920 MHz, anti-resonant frequency: 953 MHz

### Third parallel arm resonator P3:

IDT electrode wavelength: 4.2743 µm, reflector wavelength: 4.2743 µm, intersection width: 69.02 µm, number of IDT electrode pairs: 75, number of reflector pairs: 4.5, duty ratio ratio: 0.569, resonant frequency: 908 MHz, anti-resonant frequency: 941 MHz

### Third series arm resonator S3:

IDT electrode wavelength: 4.1176 µm, reflector wavelength: 4.1176 µm, intersection width: 102.35 µm, number of IDT electrode pairs: 21, number of reflector pairs: 4.5, duty ratio ratio: 0.569, resonant frequency: 936 MHz, anti-resonant frequency: 967 MHz

### Fourth parallel arm resonator P4:

IDT electrode wavelength: 4.1863 µm, reflector wavelength: 4.1863 µm, intersection width: 67.84 µm, number of IDT electrode pairs: 53, number of reflector pairs: 3.5, duty ratio ratio: 0.569, resonant frequency: 922 MHz, anti-resonant frequency: 956 MHz
Inductor 13a: 7.2 nH
Inductor 13b: 7.1 nH

### Design parameter for the elastic wave filter 400:

### First parallel arm resonator 107a:

IDT electrode wavelength: 4.2647 µm, reflector wavelength: 4.2647 µm, intersection width: 40.78 µm, number of IDT electrode pairs: 66, number of reflector pairs: 4.5, duty ratio: 0.569, resonant frequency: 909 MHz, anti-resonant frequency: 942 MHz

### First series arm resonator 104a:

IDT electrode wavelength: 4.6471 µm, reflector wavelength: 4.6471 µm, intersection width: 55.69 µm, number of IDT electrode pairs: 104, number of reflector pairs: 4.5, duty ratio: 0.569, resonant frequency: 842 MHz, anti-resonant frequency: 873 MHz

### Second parallel arm resonator 107b:

IDT electrode wavelength: 4.7353 µm, reflector wavelength: 4.7353 µm, intersection width: 40 µm, number of IDT electrode pairs: 94, number of reflector pairs: 4.5, duty ratio: 0.569, resonant frequency: 827 MHz, anti-resonant frequency: 857 MHz

### Second series arm resonator 104b:

IDT electrode wavelength: 4.2255 µm, reflector wavelength: 4.2255 µm, intersection width: 70.2 µm, number of IDT electrode pairs: 62, number of reflector pairs: 4.5, duty ratio: 0.569, resonant frequency: 919 MHz, anti-resonant frequency: 951 MHz

### Third parallel arm resonator 107c:

IDT electrode wavelength: 4.2549 µm, reflector wavelength: 4.2549 µm, intersection width: 58.04 µm, number of IDT electrode pairs: 94, number of reflector pairs: 4.5, duty ratio: 0.569, resonant frequency: 912 MHz, anti-resonant frequency: 945 MHz

### Third series arm resonator 104c:

IDT electrode wavelength: 4.1373 µm, reflector wavelength: 4.1373 µm, intersection width: 49.41 µm, number of IDT electrode pairs: 58, number of reflector pairs: 4.5, duty ratio: 0.569, resonant frequency: 934 MHz, anti-resonant frequency: 967 MHz

### Fourth parallel arm resonator 107d:

IDT electrode wavelength: 4.1667 µm, reflector wavelength: 4.1667 µm, intersection width: 54.9 µm, number of IDT electrode pairs: 52, number of reflector pairs: 4.5, duty ratio: 0.569, resonant frequency: 926 MHz, anti-resonant frequency: 960 MHz
Inductor 105a: 3.6 nH
Inductor 105b: 4.8 nH
Inductor 105c: 4.6 nH

It can be seen from the results illustrated in Fig. 12 that the elastic wave filter 2 of the present embodiment, although having fewer inductors than the three-filter-stage elastic wave filter 400, realizes attenuation characteristics equal to or better than those of the three-filter-stage elastic wave filter 400.

### (Third embodiment)

Fig. 13 is a schematic diagram of an elastic wave filter 4 according to a third embodiment. Referring to Fig. 13, in the elastic wave filter 4 of the present embodiment, the elastic wave filters 1 described above are connected in series in two stages. More specifically, the elastic wave filter 4 includes first to fourth series arm resonators S1 to S4 connected in series to one another arranged on a series arm 12. An inductor 13a is connected between a connection node 14 of the first series arm resonator S1 and an input terminal 10 and a connection node 15 of the second series arm resonator S2 and the third series arm resonator S3. In addition an inductor 13c is connected between the connection node 15 and a connection node 8 of the fourth series arm resonator S4 and an output terminal 11. First to fifth parallel arms 16a to 16e are connected between the ground potential and the connection nodes 14, 15, and 8, between the ground potential and a connection node 17 of the first series arm resonator S1 and the second series arm resonator S2, and between the ground potential and a connection node 9 of the third series arm resonator S3 and the fourth series arm resonator S4. First to fifth parallel arm resonators P1 to P5 are respectively arranged on the first to fifth parallel arms 16a to 16e.

The elastic wave filter 4 of the present embodiment has two stop bands located on the higher-frequency side of a pass band.

Also in the present embodiment, the anti-resonant frequency of the first series arm resonator S1 is made to be equal to or lower than the resonant frequency of the second series arm resonator S2 similarly to the first embodiment described above. Further, the anti-resonant frequency of the third series arm resonator S3 is made to be equal to or lower than the resonant frequency of the fourth series arm resonator S4.

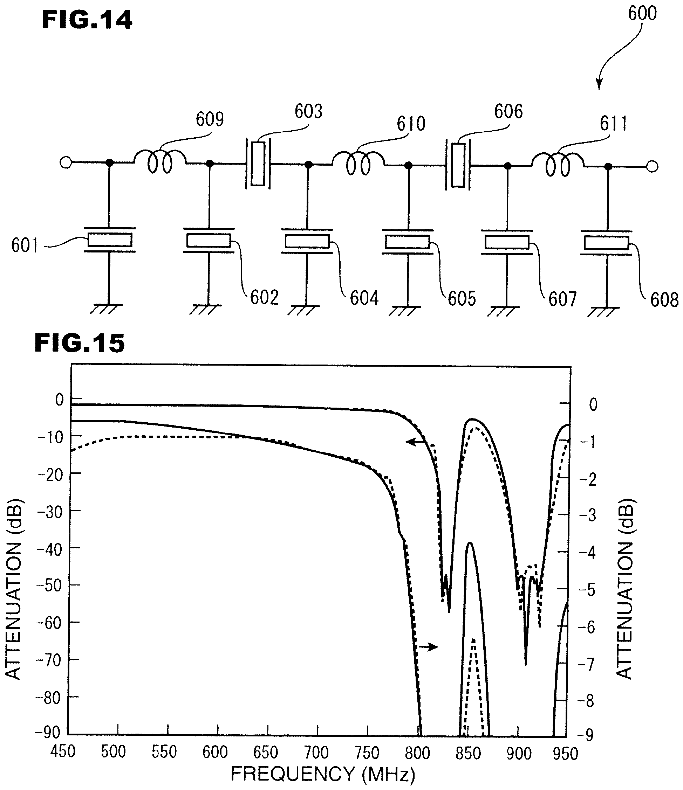

Fig. 15 illustrates the attenuation characteristics of the elastic wave filter 3 of the present embodiment. For comparison, the attenuation characteristics of an elastic-wave band pass filter 600, as illustrated in Fig. 14, are also illustrated in Fig. 15. In Fig. 15, the solid lines denote the attenuation characteristics of the elastic wave filter 4 of the third embodiment, and the broken lines denote the attenuation characteristics of the elastic wave filter 600 illustrated in Fig. 14. Note that in Fig. 15, the design parameters for the elastic wave filter 4 and the design parameters for the elastic wave filter 600 are as follows.

### Design parameter for the elastic wave filter 4

### First parallel arm resonator P1:

IDT electrode wavelength: 4.2785 µm, reflector wavelength: 4.2785 µm, intersection width: 57.88 µm, number of IDT electrode pairs: 70, number of reflector pairs: 4.5, duty ratio: 0.569, resonant frequency: 905 MHz, anti-resonant frequency: 939 MHz

### First series arm resonator S1:

IDT electrode wavelength: 4.7431 µm, reflector wavelength: 4.7431 µm, intersection width: 85.88 µm, number of IDT electrode pairs: 109, number of reflector pairs: 1.5, duty ratio: 0.569, resonant frequency: 826 MHz, anti-resonant frequency: 857 MHz

### Second parallel arm resonator P2:

IDT electrode wavelength: 4.7823 µm, reflector wavelength: 4.7823 µm, intersection width: 42.59 µm, number of IDT electrode pairs: 53, number of reflector pairs: 4.5, duty ratio: 0.569, resonant frequency: 819 MHz, anti-resonant frequency: 848 MHz

### Second series arm resonator S2:

IDT electrode wavelength: 4.1765 µm, reflector wavelength: 4.1765 µm, intersection width: 80.24 µm, number of IDT electrode pairs: 60 number of reflector pairs: 4.5, duty ratio: 0.619, resonant frequency: 926 MHz, anti-resonant frequency: 960 MHz

### Third parallel arm resonator P3:

IDT electrode wavelength: 4.1765 µm, reflector wavelength: 4.1765 µm, intersection width: 81.88 µm, number of IDT electrode pairs: 85, number of reflector pairs: 3.5, duty ratio: 0.569, resonant frequency: 924 MHz, anti-resonant frequency: 960 MHz

### Third series arm resonator S3:

IDT electrode wavelength: 4.7039 µm, reflector wavelength: 4.7039 µm, intersection width: 72.42 µm, number of IDT electrode pairs: 95, number of reflector pairs: 4.5, duty ratio: 0.569, resonant frequency: 832 MHz, anti-resonant frequency: 862 MHz

### Fourth parallel arm resonator P4:

IDT electrode wavelength: 4.8117 µm, reflector wavelength: 4.8117 µm, intersection width: 81.41 µm, number of IDT electrode pairs: 33, number of reflector pairs: 4.5, duty ratio: 0.569, resonant frequency: 814 MHz, anti-resonant frequency: 842 MHz

### Fourth series arm resonator S4:

IDT electrode wavelength: 4.1765 µm, reflector wavelength: 4.1765 µm, intersection width: 65.18 µm, number of IDT electrode pairs: 72, number of reflector pairs: 4.5, duty ratio: 0.619, resonant frequency: 926 MHz, anti-resonant frequency: 960 MHz

### Fifth parallel arm resonator P5:

IDT electrode wavelength: 4.3187 µm, reflector wavelength: 4.3187 µm, intersection width: 86.54 µm, number of IDT electrode pairs: 61, number of reflector pairs: 4.5, duty ratio: 0.569, resonant frequency: 900 MHz, anti-resonant frequency: 934 MHz
Inductor 13a: 9.5 nH
Inductor 13c: 10.0 nH

### Design parameters for the elastic wave filter 600:

### First parallel arm resonator 601:

IDT electrode wavelength: 4.6863 µm, reflector wavelength: 4.6863 µm, intersection width: 69.16 µm, number of IDT electrode pairs: 49, number of reflector pairs: 4.5, duty ratio: 0.385

### Second parallel arm resonator 602:

IDT electrode wavelength: 5.2647 µm, reflector wavelength: 5.2647 µm, intersection width: 45 µm, number of IDT electrode pairs: 39, number of reflector pairs: 3.5, duty ratio: 0.385

### First series arm resonator 603:

IDT electrode wavelength: 5.6667 µm, reflector wavelength: 5.6667 µm, intersection width: 82.8 µm, number of IDT electrode pairs: 105, number of reflector pairs: 1.5, duty ratio: 0.391

### Third parallel arm resonator 604:

IDT electrode wavelength: 4.8039 µm, reflector wavelength: 4.8039 µm, intersection width: 49.26 µm, number of IDT electrode pairs: 74, number of reflector pairs: 1.5, duty ratio: 0.385

### Fourth parallel arm resonator 605:

IDT electrode wavelength: 4.8235 µm, reflector wavelength: 4.8235 µm, intersection width: 51.43 µm, number of IDT electrode pairs: 43, number of reflector pairs: 4.5, duty ratio: 0.385

### Second series arm resonator 606:

IDT electrode wavelength: 5.6471 µm, reflector wavelength: 5.6471 µm, intersection width: 67.27 µm, number of IDT electrode pairs: 105, number of reflector pairs: 1.5, duty ratio: 0.391

### Fifth parallel arm resonator 607:

IDT electrode wavelength: 4.7157 µm, reflector wavelength: 4.7157 µm, intersection width: 53.16 µm, number of IDT electrode pairs: 52, number of reflector pairs: 4.5, duty ratio: 0.385

### Sixth parallel arm resonator 608:

IDT electrode wavelength: 5.3039 µm, reflector wavelength: 5.3039 µm, intersection width: 45 µm, number of IDT electrode pairs: 63, number of reflector pairs: 4.5, duty ratio: 0.385
Inductor 609: 19 nH
Inductor 610: 27 nH
Inductor 611: 19 nH

It can be seen from the results illustrated in Fig. 15 that the elastic wave filter 4 of the present embodiment, although having fewer inductors than the elastic wave filter 600, realizes attenuation characteristics equal to or better than those of the elastic wave band pass filter 600 and also a smaller insertion loss in the pass band than the elastic-wave band-pass filter 600.

In the present embodiment, description has been made of an example in which the elastic wave filters of the first embodiment are connected in series in two stages. However, the present invention is not limited to this configuration. In the present invention, the elastic wave filters 1 of the first embodiment may be connected in series in more than two stages. By increasing the number of stages in this manner, more attenuation poles can be formed.

### (Fourth embodiment)

An elastic wave filter of the present embodiment has a configuration similar to that of the elastic wave filter of the third embodiment described above. Hence, Fig. 13, which was referred to in the third embodiment described above, is also referred to in the present embodiment.

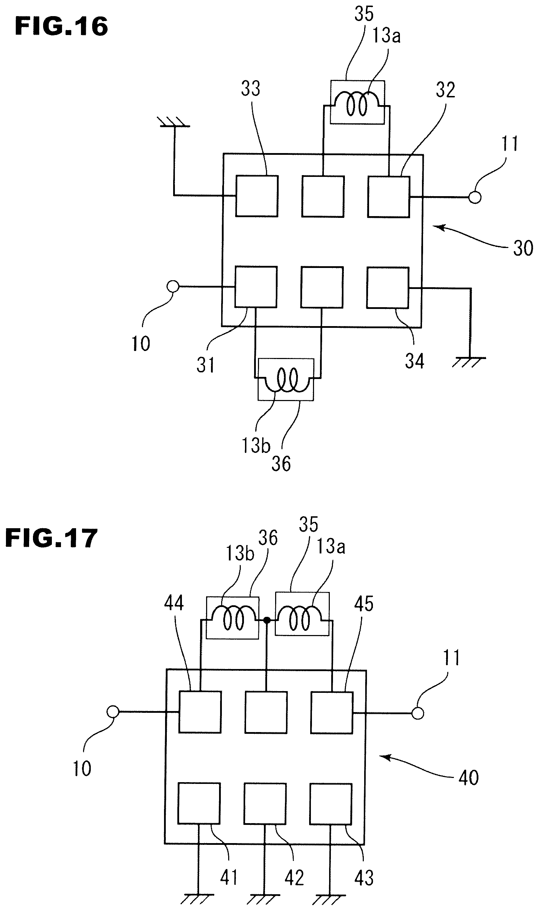

Referring to Fig. 16, in the present embodiment, the elastic wave filter is provided with a filter chip 30 which is a filter body formed by sealing, with a resin, an alumina substrate that includes a piezoelectric substrate, mounted thereon, on which first to third series arm resonators S1 to S3 and first to fourth parallel arm resonators P1 to P4 are formed. The filter chip 30 has an input end electrode 31 connected to an input terminal 10 and an output end electrode 32 connected to an output terminal 11 formed on the back surface thereof. The input end electrode 31 and the output end electrode 32 are arranged point-symmetrically with respect to the center of the filter chip 30 as the filter body, when viewed from the back surface.

On the back surface of the filter chip 30, ground terminal electrodes 33 and 34 to be connected to the ground potential are also formed. The ground terminal electrodes 33 and 34 are point-symmetrically arranged with respect to the center of the elastic wave filter, i.e., the center of the filter chip 30 when viewed from the back surface.

Further, in the present embodiment, inductors 13a and 13b are respectively formed within inductor chips 35 and 36. The inductor chips 35 and 36 are mounted on the filter chip 30.

Fig. 18 illustrates the attenuation characteristics of the elastic wave filter of the present embodiment. For comparison, Fig. 18 also illustrates the attenuation characteristics of an elastic wave filter in which ground terminal electrodes 41 to 43 are not arranged point-symmetrically with respect to the center of a filter chip 40, and also, an input end electrode 44 and output end electrode 45 are not arranged point-symmetrically with respect to the center of a filter chip 40, as illustrated in Fig. 17. In Fig. 18, the solid lines denote the attenuation characteristics of the elastic wave filter of the fourth embodiment, and the broken lines denote the attenuation characteristics of the elastic wave filter illustrated in Fig. 17. Note that, in Fig. 18, the design parameters for the elastic wave filter of the fourth embodiment and the design parameters for the elastic wave filter illustrated in Fig. 17 are similar to those for the elastic wave filter of the third embodiment described above.

It can be seen from the results illustrated in Fig. 18 that higher attenuation characteristics are obtained when the input end electrode and the output end electrode are arranged point-symmetrically with respect to the center of the filter chip 30 and a plurality of the ground terminal electrodes are point-symmetrically arranged with respect to the center of the filter chip 30 than when they are not arranged point-symmetrically.

Note that the inductors need not be constituted by inductor chips provided separately from the filter body. The inductors may be constituted by, for example, coil patterns formed on the filter body.

### Reference Signs List

S1 first series arm resonator
S2 second series arm resonator
S3 third series arm resonator
S4 fourth series arm resonator
P1 first parallel arm resonator
P2 second parallel arm resonator
P3 third parallel arm resonator
P4 fourth parallel arm resonator
P5 fifth parallel arm resonator
1-5 elastic wave filters
8, 9, 14, 15, 17, 18 connection nodes
10 input terminal
11 output terminal
12 series arm
13a inductor
13b inductor
13c inductor
16a first parallel arm
16b second parallel arm
16c third parallel arm
16d fourth parallel arm
20 surface acoustic wave resonator
21 piezoelectric substrate
22 IDT electrode
22a, 22b comb-shaped electrodes
23 first grating reflector
24 second grating reflector
30 filter chip
31 input end electrode
32 output end electrode
33, 34 ground terminal electrodes
35, 36 inductor chips
40 filter chip
41-43 ground terminal electrodes
44 input end electrode
45 output end electrode

## Claims

1. An elastic wave filter (1) comprising:
a plurality of series arm resonators (S1,S2) connected in series to one another on a series arm (12) connecting an input terminal (10) to an output terminal (11);
a first inductor (13a) connected to first (14) and second (15) connection nodes on the series arm (12) in such a manner as to be in parallel with a series connection of two or more (S1,S2) of the plurality of the series arm resonators; and
a plurality of parallel arm resonators (P1-P3) arranged on a parallel arm (16a) connecting the first connection node (14) to a ground potential, on a parallel arm (16c) connecting the second connection node (15) to a ground potential, and on a parallel arm (16b) connecting a further connection node (17), between adjacent series arm resonators (S1,S2) of said series connection, to the ground potential;
wherein the two or more series arm resonators of said series connection include a first series arm resonator (S1) and a second series arm resonator (S2) that has a resonant frequency equal to or higher than an anti-resonant frequency of the first series arm resonator (S1); and
wherein resonant points of the parallel arm resonators (P1-P3) form two attenuation regions in the passband of the elastic wave filter, and the first inductor (13a) forms with equivalent circuits of the first and second series arm resonators (S1,S2) an LC filter having two attenuation poles arranged in said two attenuation regions.

2. The elastic wave filter (2) according to Claim 1, comprising a second filter stage having a series path, and a second inductor (13b) which is connected in parallel to the series path of said second filter stage.

3. The elastic wave filter according to Claim 2,
wherein the elastic wave filter has a filter body (30) which has the plurality of the series arm resonators and the plurality of the parallel arm resonators formed thereon and said first and second inductor (13a,13b) connected thereto, and
wherein said first and second inductors (13a,13b) are arranged point-symmetrically with respect to a center of the filter body (30).

4. The elastic wave filter (1) according to any one of Claims 1 to 3, wherein the series connection comprises two of the plurality of the series arm resonators (S1,S2), and each of the plurality of the parallel arms (16a-16c) has one of the plurality of the parallel resonators (P1-P3).

5. The elastic wave filter according to any one of Claims 1 to 4, further comprising a plurality of ground terminal electrodes (33,34) to which the plurality of the parallel arms (16a-16c) are connected, wherein the plurality of the ground terminal electrodes (33,34) are point-symmetrically arranged with respect to a center of the elastic wave filter.

## Patentansprüche

1. Filter (1) für elastische Wellen, umfassend:
mehrere miteinander in Reihe geschaltete Reihenarmresonatoren (S1,S2) an einem Reihenarm (12), der einen Eingangsanschluss (10) mit einem Ausgangsanschluss (11) verbindet,
einen ersten Induktor (13a), der mit einem ersten (14) und einem zweiten (15) Verbindungsknoten an dem Reihenarm (12) derart verbunden ist, dass sie parallel zu einer Reihenschaltung von zwei oder mehr (S1 ,S2) der mehreren Reihenarmresonatoren ist, und
mehrere Parallelarmresonatoren (P1-P3), die an einem Parallelarm (16a), der den ersten Verbindungsknoten (14) mit einem Erdungspotential verbindet, an einem Parallelarm (16c), der den zweiten Verbindungsknoten (15) mit einem Erdungspotential verbindet, und an einem Parallelarm (16b), der einen weiteren Verbindungsknoten (17) zwischen benachbarten Reihenarmresonatoren (S1,S2) der Reihenschaltung mit dem Erdungspotential verbindet, angeordnet sind,
wobei die zwei oder mehr Reihenarmresonatoren der Reihenschaltung einen ersten Reihenarmresonator (S1) und einen zweiten Reihenarmresonator (S2), der eine Resonanzfrequenz gleich einer oder höher als eine Antiresonanzfrequenz des ersten Reihenarmresonators (S1) aufweist, beinhalten, und
wobei Resonanzpunkte der Parallelarmresonatoren (P1-P3) zwei Dämpfungsbereiche im Durchlassband des Filters für elastische Wellen ausbilden und die erste Induktor (13a) mit äquivalenten Schaltungen des ersten und des zweiten Reihenarmresonators (S1,S2) ein LC-Filter mit zwei Dämpfungspolen, die in den beiden Dämpfungsbereichen angeordnet sind, ausbildet.

2. Filter für elastische Wellen (2) nach Anspruch 1, das eine zweite Filterstufe, die einen Reihenpfad aufweist, und einen zweiten Induktor (13b) umfasst, der parallel zu dem Reihenpfad der zweiten Filterstufe geschaltet ist.

3. Filter für elastische Wellen nach Anspruch 2,
wobei das Filter für elastische Wellen einen Filterkörper (30) aufweist, an dem die mehreren Reihenarmresonatoren und die mehreren Parallelarmresonatoren ausgebildet und mit dem der erste und der zweite Induktor (13a, 13b) verbunden sind, und
wobei der erste und der zweite Induktor (13a,13b) punktsymmetrisch in Bezug auf eine Mitte des Filterkörpers (30) angeordnet sind.

4. Filter für elastische Wellen (1) nach einem der Ansprüche 1 bis 3, wobei die Reihenschaltung zwei der mehreren Reihenarmresonatoren (S1,S2) umfasst und jeder der mehreren Parallelarme (16a-16c) einen der mehreren Parallelresonatoren (P1-P3) aufweist.

5. Filter für elastische Wellen nach einem der Ansprüche 1 bis 4, ferner umfassend mehrere Erdungsanschlusselektroden (33,34), mit denen die mehreren Parallelarme (16a-16c) verbunden sind, wobei die mehreren Erdungsanschlusselektroden (33,34) punktsymmetrisch in Bezug auf eine Mitte des Filters für elastische Wellen angeordnet sind.

## Revendications

1. Filtre à ondes élastiques (1) comprenant :
une pluralité de résonateurs de branche en série (S1, S2) connectés en série les uns aux autres sur une branche en série (12) connectant une borne d'entrée (10) à une borne de sortie (11) ;
un premier inducteur (13a) connecté à des premier (14) et second (15) noeuds de connexion sur la branche en série (12) de manière à être en parallèle avec une connexion en série de deux (S1, S2) ou plus de la pluralité de résonateurs de branche en série ; et
une pluralité de résonateurs de branche en parallèle (P1-P3) agencés sur une branche en parallèle (16a) connectant le premier noeud de connexion (14) à un potentiel de masse, sur une branche en parallèle (16c) connectant le second noeud de connexion (15) à un potentiel de masse, et sur une branche en parallèle (16b) connectant un autre noeud de connexion (17), entre des résonateurs de branche en série adjacents (S1, S2) de ladite connexion en série, au potentiel de masse ;
dans lequel les deux résonateurs de branche en série ou plus de ladite connexion en série comprennent un premier résonateur de branche en série (S1) et un second résonateur de branche en série (S2) qui a une fréquence de résonance égale ou supérieure à une fréquence d'antirésonance du premier résonateur de branche en série (S1) ; et
dans lequel des points de résonance des résonateurs de branche en parallèle (P1-P3) forment deux régions d'atténuation dans la bande passante du filtre à ondes élastiques, et le premier inducteur (13a) forme, avec des circuits équivalents des premier et second résonateurs de branche en série (S1, S2), un filtre LC ayant deux pôles d'atténuation agencés dans lesdites deux régions d'atténuation.

2. Filtre à ondes élastiques (2) selon la revendication 1, comprenant un second étage de filtre ayant une voie en série, et un second inducteur (13b) qui est connecté en parallèle à la voie en série dudit second étage de filtre.

3. Filtre à ondes élastiques selon la revendication 2, dans lequel le filtre à ondes élastiques comprend un corps de filtre (30) sur lequel la pluralité de résonateurs de branche en série et la pluralité de résonateurs de branche en parallèle sont formés et auquel lesdits premier et second inducteurs (13a, 13b) sont connectés, et
dans lequel lesdits premier et second inducteurs (13a, 13b) sont agencés selon une symétrie ponctuelle par rapport à un centre du corps de filtre (30).

4. Filtre à ondes élastiques (1) selon l'une quelconque des revendications 1 à 3, dans lequel la connexion en série comprend deux de la pluralité des résonateurs de branche en série (S1, S2), et chacune de la pluralité des branches en parallèle (16a-16c) comprend l'un de la pluralité des résonateurs en parallèle (P1-P3).

5. Filtre à ondes élastiques selon l'une quelconque des revendications 1 à 4, comprenant en outre une pluralité d'électrodes de borne de masse (33, 34) auxquelles la pluralité des branches en parallèle (16a-16c) sont connectées, dans lequel la pluralité d'électrodes de borne de masse (33, 34) sont agencées selon une symétrie ponctuelle par rapport à un centre du filtre à ondes élastiques.
